# EUROPEAN PATENT APPLICATION

(11) **EP 0 698 930 A1**
(43) Date of publication of application: **28.02.1996**
(21) Application number: 95107170.3
(22) Date of filing: 11.05.1995
(51) Int. Cl.: H01L 39/24

(54) **Oxide superconductor and fabrication method of the same**

(30) Priority: 26.08.1994 JP 201733/94
(71) Applicant: HITACHI, LTD., Chiyoda-ku, Tokyo 101 (JP)
(72) Inventor: Okada, Michiya, Mito-shi, Ibaraki 311-11 (JP); Tanaka, Kazuhide, Hitachi-shi, Ibaraki 319-12 (JP); Fukushima, Kenji, Hitachi-shi, Ibaraki 316 (JP)
(74) Representative: Dost, Wolfgang, Dr.rer.nat., Dipl.-Chem.

(57) **Abstract**

Disclosed is an oxide superconductor wire which has a twisted structure having a high density and a high mechanical strength and is capable of simultaneously achieving the densification and orientation. The oxide superconductor includes a volume variable portion increased in volume by heat-treatment, a superconducting portion made of an oxide superconductor material which is formed around the outer periphery of the volume variable portion; and a sheath portion formed around the outer periphery of the superconducting portion.

## Description

### BACKGROUND OF THE INVENTION

The present invention relates to an oxide superconductor and a fabrication method of the same.

It is well known that oxide superconductors, which have discovered in 1986, have a number of excellent properties compared with conventional metal materials. In particular, they have critical temperatures Tc higher than the liquid nitrogen temperature and critical magnetic fields more than 30 tesla. These characteristics of oxide superconductors make it possible to generate an ultra high magnetic field of 25 tesla or more which has been impossible to be obtained by conventional metal materials, and to realize a superconductive magnetic system by cooling using liquid nitrogen.

Pan-cake like coils of such high temperature superconductors have been described, for example in ("Low Temperature Engineering", Vol. 27, No. 1, 1992, p. 70 - 76), or in ("Superconducting Communications", Vol. 12, No. 3, 1993) both documents incorporated herein by reference.

In each of the prior arts described above, an oxide superconductor coated with silver is formed into a thin tape shape, and the tape-shaped wire is wound into a pan-cake coil. The material of the oxide superconductor is represented by T*e*₂Ba₂Ca₂Cu₃Oₓ and (Bi,Pb)₂Sr₂Ca₂Cu₃Oₓ.

In the oxide superconductors of the prior art, it is difficult to prevent the generation of cracks in a compacting and a bending process. For this reason, the oxide superconductors cannot be formed into a twisted cable structure which can be usually obtained using metal based superconductors. Moreover, the oxide superconductors composed of ceramics have a limitation to the densifying, and thereby contain many voids between particles of filaments. In addition, they are extremely difficult to be formed in a twisted cable structure without harming orientation. The oxide superconductor of the prior art also have disadvantages in terms of stability because of heat-generation due to the alternating current loss when being applied to ac wires (such as superconductor generators, motors, feed cables, ac magnets and pulse magnets).

As described above, since oxide super-conductors are composed of ceramics difficult to be plastically deformed, they have a limitation in forming long-size products and in forming multi-core wires by the conventional drawing and rolling method.

An object of the present invention, therefore, is to provide a wire having a twisted structure being dense and excellent in mechanical strength, wherein an oxide superconductor can be simultaneously densified and oriented.

### SUMMARY OF THE INVENTION

To achieve the above object, according to a first aspect of the present invention, there is provided an oxide superconductor including a volume variable portion increased in volume by heat-treatment; a superconducting portion made of an oxide superconductor material which is formed around the outer periphery of the volume variable portion; and a sheath portion formed around the outer periphery of the superconducting portion.

According to a second aspect of the present invention, there is provided a method of fabricating an oxide superconductor comprising the steps of: filling a sheath portion with a precursor of an oxide superconductor; forming the filaments obtained by the filling process into a twisted conductor; and heat-treating the conductor.

According to one specifice embodiment of the invention, the sheath portion is formed of a material which is chemically inactive with the oxide superconductor in the heat-treatment process, for example, tin, lead, thallium or indium.

According to another specific embodiment, the volume variable portion is formed of, before the heat-treatment process, a high melting point metal such as titanium or zirconium and the alloy thereof; aluminum or aluminum alloy; and titanium alloy, zirconium alloy, steel or stainless steel, which contains aluminum in an amount of from 1 to 10%.

According to still a further specific embodiment, the superconducting portion, volume variable portion and sheath portion constituting the conductor comprise flat sections and are laminated so as to be in parallel to the flat planes.

According to an even further specific embodiment, the superconductor wire is wound into a solenoid coil or pan-cake shape and is subjected to heat-treatment for varying the volume.

According to still a further embodiment, the superconductor wires are collected into a cable or a current lead shape and subjected to heat-treatment for varying the volume.

According to even a further embodiment, the sheath portion is formed into a shape of a mesh, wire or tape.

### DESCRIPTION OF THE DRAWINGS

For a more complete understanding of the present invention and for further advantages thereof, reference is made to the following Detailed Description taken in conjunction with the accompanying drawings, in which:
Fig. 1 is a schematic view of an example of a conductor having a twisted structure according to an embodiment of the present invention;
Fig. 2 is a schematic view of an example of a conductor having a two-way twisted structure according to an embodiment of the present invention;
Fig. 3 is a schematic view of an example of a conductor having a twisted structure with a rectangular section according to an embodiment of the present invention;
Fig. 4 is a schematic view of an example of a superconductor having a secondary twisted structure according to an embodiment of the present invention;
Fig. 5 is a sectional view of an example of a superconductor according to an embodiment of the present invention;
Fig. 6 is a sectional view of an example of a superconductor according to an embodiment of the present invention;
Fig. 7 is a sectional view of an example of a superconductor having a modified sectional structure according to an embodiment of the present invention;
Fig. 8 is a sectional view of an example of a superconductor having a modified sectional structure according to an embodiment of the present invention;
Fig. 9 is a sectional view of an example of a superconductor having a modified sectional structure according to an embodiment of the present invention;
Fig. 10 is a sectional view of an example of a superconductor having a modified sectional structure according to an embodiment of the present invention;
Fig. 11 is a sectional view of an example of a superconductor having a modified sectional structure according to an embodiment of the present invention;
Fig. 12 is a sectional view of an example of a superconductor having a modified sectional structure according to an embodiment of the present invention;
Fig. 13 is a sectional view of an example of a superconductor having a modified sectional structure according to an embodiment of the present invention;
Fig. 14 is a sectional view of an example of a superconductor having a modified sectional structure before heat-treatment according to an embodiment of the present invention;
Fig. 15 is a sectional view of an example of a superconductor having a modified sectional structure according to an embodiment of the present invention;
Fig. 16 is a fabrication method for an example of a superconductor according to an embodiment of the present invention;
Fig. 17 is a graph showing a relationship between Jc and the wire diameter for a comparison between an example of a superconductor according to an embodiment of the present invention and a comparative superconductor;
Fig. 18 is a sectional view of an example of a superconductor having a modified sectional structure according to an embodiment of the present invention;
Fig. 19 is a sectional view of an example of a superconductor having a modified sectional structure according to an embodiment of the present invention;
Fig. 20 is a sectional view of an example of a superconductor having a modified sectional structure according to an embodiment of the present invention;
Fig. 21 is a sectional view of an example of a superconductor having a modified sectional structure according to an embodiment of the present invention;
Fig. 22 is a schematic view of a superconductor coil using an example of a superconductor according to an embodiment of the present invention;
Fig. 23 is a schematic view of a winding machine for a superconductor coil using an example of a superconductor according to an embodiment of the present invention;
Fig. 24 is a schematic view of a superconductor coil using an example of a superconductor according to an embodiment of the present invention;
Fig. 25 is a schematic view of a superconductor coil system using an example of a superconductor according to an embodiment of the present invention;
Fig. 26 is a schematic view of a superconductor coil system using an example of a superconductor according to an embodiment of the present invention; and
Fig. 27 is a schematic view of a superconductor coil system using an example of a superconductor according to an embodiment of the present invention.

It is to be noted, however, that the appended drawings illustrate only typical embodiments of this invention and are therefore not to be considered limiting of its scope, for the invention may admit to other equally effective embodiments.

### DETAILED DESCRIPTION OF EMBODIMENTS OF THE INVENTION

The present invention concerns a new high temperature superconductor densified using a material being chemically inactive with the superconductor and is expanded by the volume variation thereof. Namely, the superconductor including a superconducting portion, volume variable portion and sheath portion is compressed/densified by the volume expansion of the above volume variable portion in a heat-treatment process. This makes it possible to densify the oxide superconductor over the whole length even when it has the long-sized and complex shape, such as the twisted structure and coil shape. Such densification has been considered to be impossible. Moreover, the sectional shape of the conductor is not substantially limited, that is, it is not limited to a tape shape which has been conventionally used. As for the orientation, using such a property of superconductor crystals that the C-axes of the crystals are arranged perpendicularly to the direction to which a pressurizing force by the expansion in volume is applied, even the wire and coils with the complex shape described above can be oriented by arranging the volume variable type insulating material at a suitable geometric position.

The volume variable materials may include, but not limited to, metals liable to be oxidized, such as titanium, zirconium and magnesium being not substantially reacting with the oxide superconductor. In accordance with the application, the above metal may be formed into a shape of tape, powder, tube and mesh. The expansion is generated upon the volume variation from metal to metal oxide. To adjust the expansion coefficient, there may be used a mixture in which a metal is added with the oxide of the metal.

The materials of the oxide superconductors are not particularly limited, and may include the following known conductive materials:

### (A) TeₐBa_{b}Ca_{c}Cu_{d}Oₑ system

In this system, the following materials are useful.
(1) a: b: c: d: e = (1.8-2.2):(1.8-2.2):(1.8-2.2):(2.7-3.3):(9-10)
(2) a: b: c: d: e = (1.8-2.2):(1.8-2.2):(0.8-1.1):(1.8-2.2):(7.2-8.8)
(3) a: b: c: d: e = (1.8-2.2):(1.8-2.2):(0):(0.9-1.1):(5.4-6.6)
(4) a: b: d: e = (1.5-2.2):(1.5-2.2): (0.5-1.3):(5-7)
(5) a: b: c: d: e = (1.5-2.2):(1.5-2.2): (0.5-1.3):(1.5-2.3): (7-9)
(6) a: b: c: d: e = (1.5-2.2):(1.5-2.3):(1.5-2.3):(2.5-3.3): (9-11)
(7) a: b: d: e = (0.5-1.2):(1.5-2.2):(0.5-1.3):(4-6)
(8) a: b: c: d: e = (0.5-1.2):(1.5-2.2):(0.5-1.2):(1.5-2.3): (6-8)
(9) a: b: c: d: e = (0.5-1.2):(1.5-2.2):(2.5-3.2):(3.5-4.3):(8-10)

### (B) Teₐ-Sr_{b}-Ca_{c}-Cu_{d}-Oₑ system

In this system, the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.5-2.3):(7-9)
(3) a: b: c: d: e = (1.5-2.2):(1.5-2.3):(1.5-2.3):(2.5-3.3): (9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3): (6-8)
(6) a: b: c: d: e = (0.5-1.2):(1.5-2.2):(2.5-3.2):(3.5-4.3): (8-10)

### (C) Teₐ-(Ba₁-ₓ-Srₓ)_{b}-Ca_{c}-Cu_{d}-Oₑ system

In this system (x = 0-0.5), the following materials are useful.
(1) a: b: c: d: e = (1.8-2.2):(1.8-2.2):(1.8-2.2):(2.7-3.3):(9-11)
(2) a: b: c: d: e = (1.8-2.2):(1.8-2.2):(0.9-1.1):(1.8-2.2):(7-9)
(3) a: b: c: d: e = (1.8-2.2):(1.8-2.2):(0):(0.9-1.1):(5.4-6.6)

### (D) Teₐ-(Ba₁-ₓ-Srₓ)_{b}-Ca_{c}-Cu_{d}-Oₑ system

In this system (x = 0.1-0.9), the following materials are useful.
(1) a: b: c: d: e = (0.8-1.2):(1.8-2.2):(1.8-2.2):(2.7-3.3):(9-11)
(2) a: b: c: d: e = (0.8-1.2):(1.8-2.2):(0.9-1.1):(1.8-2.2):(7-9)
(3) a: b: c: d: e = (0.8-1.2):(1.8-2.2):(0):(0.9-1.1):(5.4-6.6)
(4) a: b: d: e = (1.5-2.2):(1.5-2.2):(0.5-1.3):(5-7)
(5) a: b: c: d: e = (1.5-2.2):(1.5-2.2):(0.5-1.3):(1.5-2.3):(7-9)
(6) a: b: c: d: e = (1.5-2.2):(1.5-2.3):(1.5-2.3):(2.5-3.3):(9-11)
(7) a: b: d: e = (0.5-1.2):(1.5-2.2):(0.5-1.3):(4-6)
(8) a: b: c: d: e = (0.5-1.2):(1.5-2.2):(0.5-1.2):(1.5-2.3):(6-8)
(9) a: b: c: d: e = (0.5-1.2):(1.5-2.2):(2.5-3.2):(3.5-4.3):(8-10)

### (E) (Teₓ, pb₁₋ₓ)ₐ-Sr_{b}-Ca_{c}-Cu_{d}-Oₑ system

In this system (x = 0.1-0.9), the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.5-2.3):(7-9)
(3) a: b: c: d: e = (1.5-2.2):(1.5-2.3):(1.5-2.3):(2.5-3.3):(9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3):(6-8)
(6) a: b: c: d: e = (0.5-1.2):(1.5-2.2):(2.5-3.2):(3.5-4.3):(8-10)

### (F) (Te₁₋ₓ, pbₓ)ₐ-(Sr_{1-y}-Ba_{y})_{b}-Ca_{c}-Cu_{d}-Oₑ system

In this system (x = 0-0.5, y = 0-0.5), the followings are useful.
(1) a: b: c: d: e = (0.8-1.2):(1.8-2.2):(1.8-2.2):(2.7-3.3):(9-11)
(2) a: b: c: d: e = (0.8-1.2):(1.8-2.2):(0.9-1.1):(1.8-2.2):(7-9)
(3) a: b: c: d: e = (0.8-1.2):(1.8-2.2):(0):(0.9-1.1):(5.4-6.6)
In this system (x =0.1-0.9, y = 0.1-0.9), the following materials are also useful.
(4) a: b: d: e = (1.5-2.2):(1.5-2.2):(0.5-1.3):(5-7)
(5) a: b: c: d: e = (1.5-2.2):(1.5-2.2):(0.5-1.3):(1.5-2.3):(7-9)
(6) a: b: c: d: e = (1.5-2.2):(1.5-2.3):(1.5-2.3):(2.5-3.3):(9-11)
(7) a: b: d: e = (0.5-1.2):(1.5-2.2):(0.5-1.3):(4-6)
(8) a: b: c: d: e = (0.5-1.2):(1.5-2.2):(0.5-1.2):(1.5-2.3):(6-8)
(9) a: b: c: d: e = (0.5-1.2):(1.5-2.2):(2.5-3.2):(3.5-4.3):(8-10)

### (G) (Bi₁₋ₓ, pbₓ)ₐ-Sr_{b}-Ca_{c}-Cu_{d}-Oₑ system

In this system (x = 0.1-0.9), the following materials are useful.
(1) a: b: c: d: e = (1.8-2.2):(1.8-2.2):(1.8-2.2):(2.7-3.3):(9-11)
(2) a: b: c: d: e = (1.8-1.2):(1.8-2.2):(0.9-1.1):(1.8-2.2):(7-9)
(3) a: b: c: d: e = (1.8-1.2):(1.8-2.2):(0):(0.9-1.1):(5.4-6.6)
(4) a: b: d: e = (1.5-2.2):(1.5-2.2):(0.5-1.3):(5-7)
(5) a: b: c: d: e = (1.5-2.2):(1.5-2.2):(0.5-1.3):(1.5-2.3):(7-9)
(6) a: b: c: d: e = (1.5-2.2):(1.5-2.3):(1.5-2.3):(2.5-3.3):(9-11)
(7) a: b: d: e = (0.5-1.2):(1.5-2.2):(0.5-1.3):(4-6)
(8) a: b: c: d: e = (0.5-1.2):(1.5-2.2):(0.5-1.2):(1.5-2.3):(6-8)
(9) a: b: c: d: e = (0.5-1.2):(1.5-2.2):(2.5-3.2):(3.5-4.3):(8-10)

### (H) Yₐ-Ba_{b}-Cu_{c}-O_{d} system

In this system (Y is yttrium or a lanthanide group element), the following material is useful.
(1) a: b: c: d: e = (1.8-2.2):(1.8-2.2):(2.8-3.2):(6-8)

### (I) Lnₐ-Ba_{b}-Cu_{c}-O_{d} system

In this system (Ln is Y, Sc, La, Ac, Ce, Pr, Nd, Pm, Sm, Eu, Gd, Tb, Dy, Ho, Er, Tm, Yb, or Lu), the following materials are useful.
(1) a: c: d = (1.5-2.3):(0.5-1.3):(4-6)
(2) a: b: c: d: = (0.5-1.3):(1.5-2.3):(2.5-3.3):(6-8)

### (J) Lnₐ-Sr_{b}-Cu_{c}-O_{d} system

In this system (Ln is Y, Sc, La, Ac, Ce, Pr, Nd, Pm, Sm, Eu, Gd, Tb, Dy, Ho, Er, Tm, Yb, or Lu), the following materials are useful.
(1) a: b: c: d: = (0.5-1.3):(1.5-2.3):(2.5-3.3):(6-8)

### (K) (Bi₁-x-Cuₓ)ₐ-Sr_{b}-(Y_{1-y}Ca_{y})_{c}-Cu_{d}-Oₑ system

In this system (x = 0.1-0.9, y = 0.1-0.9), the following material is useful.
(1) a: b: c: d: e = 1: 2: 1: 2: 6-8

### (L) Baₐ-Ca_{b}-Cu_{c}-O_{d} system

In this system, the following material is useful.
(1) a: b: c: d = (0.5-1.2):(1.5-2.2):(0.5-1.3):(4-6)

### (M) Cuₐ-Ba_{b}-Ca_{c}-Cu_{d}-Oₑ system

In this system, the following materials are useful.
(1) a: b: c: d: e = (0.5-1.2):(1.5-2.2):(0.5-1.2):(1.5-2.3):(6-8)
(2) a: b: c: d: e = (0.5-1.2):(1.5-2.2):(2.5-3.2):(3.5-4.3):(8-10)

### (N) (Agₓ-Cu₁₋ₓ)ₐ-Ba_{b}-Ca_{c}-Cu_{d}-Oₑ system

In this system (x = 0-1), the following materials are useful.
(1) a: b: d: e = (0.5-1.2):(1.5-2.2):(0.5-1.3):(4-6)
(2) a: b: d: e = (0.5-1.2):(1.5-2.2):(1.5-2.3):(6-8)
(3) a: b: c: d: e = (0.5-1.2):(1.5-2.2):(2.5-3.2):(3.5-4.3):(8-10)

### (O) Cuₐ-Sr_{b}-Ca_{c}-Cu_{d}-Oₑ system

In this system, the following materials are useful.
(1) a: b: c: d = (0.5-1.2):(1.5-2.2):(0.5-1.3):(4-6)
(2) a: b: c: d: e = (0.5-1.2):(1.5-2.2):(0.5-1.2):(1.5-2.3):(6-8)
(3) a: b: c: d: e = (0.5-1.2):(1.5-2.2):(2.5-3.2):(3.5-4.3):(8-10)

### (P) (Agₓ-Cu₁₋ₓ)ₐ-Sr_{b}-Ca_{c}-Cu_{d}-Oₑ system

In this system (x = 0-1), the following materials are useful.
(1) a: b: d: e = (0.5-1.2):(1.5-2.2):(0.5-1.3):(4-6)
(2) a: b: c: d: e = (0.5-1.2):(1.5-2.2):(0.5-1.2):(1.5-2.3):(6-8)
(3) a: b: c: d: e = (0.5-1.2):(1.5-2.2):(2.5-3.2):(3.5-4.3):(8-10)

### (Q) Hgₐ-Ba_{b}-Ca_{c}-Cu_{d}-Oₑ system

In this system, the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.2-2.3):(7-9)
(3) a: b: c: d: e = (1.5-2.2):(1.5-2.3):(1.5-2.3):(2.5-3.3):(9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3):(6-8)
(6) a: b: c: d: e = (0.5-1.2):(1.5-2.2):(2.5-3.2):(3.5-4.3):(8-10)

### (R) Hgₐ-Sr_{b}-Ca_{c}-Cu_{d}-Oₑ system

In this system, the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.5-2.3):(7-9)
(3) a: b: c: d: e = (1.5-2.2):(1.5-2.3):(1.5-2.3):(2.5-3.3):(9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3):(6-8)
(6) a: b: c: d: e = (0.5-1.2):(1.5-2.2):(2.5-3.2):(3.5-4.3):(8-10)

### (S) Hgₐ-(Baₓ-Sr₁₋ₓ)_{b}-Ca_{c}-Cu_{d}-Oₑ system

In this system (x = 0.1-0.9), the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.5-2.3):(7-9)
(3) a: b: c: d: e = (1.5-2.2):(1.5-2.3):(1.5-2.3):(2.5-3.3):(9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3):(6-8)
(6) a: b: c: d: e = (0.5-1.2):(1.5-2.2):(2.5-3.2):(3.5-4.3):(8-10)

### (T) (Hg_{y}-Pb_{1-y})ₐ-Sr_{b}-Ca_{c}-Cu_{d}-Oₑ system

In this system (y = 0.1-0.9), the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.5-2.3):(7-9)
(3) a: b: c: d: e = (1.5-2.2):(1.5-2.3):(1.5-2.3):(2.5-3.3):(9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3):(6-8)
(6) a: b: c: d: e = (0.5-1.2):(1.5-2.2):(2.5-3.2):(3.5-4.3):(8-10)

### (U) (Hg_{y}-Pb_{1-y})ₐ-(Baₓ-Sr₁₋ₓ)_{b}-Ca_{c}-Cu_{d}-Oₑ system

In this system (x = 0.1-0.9, y =0.1-0.9), the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.5-2.3):(7-9)
(3) a: b: c: d: e = (1.5-2.2):(1.5-2.3):(1.5-2.3):(2.5-3.3):(9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3):(6-8)
(6) a: b: c: d: e = (0.5-1.2):(1.5-2.2):(2.5-3.2):(3.5-4.3):(8-10)

### (V) (Hg_{y}-T_{1-y})ₐ-(Baₓ-Sr₁-x)_{b}-Ca_{c}-Cu_{d}-Oₑ system

In this system (x = 0.1, y = 0.1-0.9), the following materials are useful.
(1) a: b: d: e = (1.5-2.2):(1.5-2.2):(0.5-1.3):(5-7)
(2) a: b: c: d: e = (1.5-2.2):(1.5-2.2):(0.5-1.3):(1.5-2.3):(7-9)
(3) a: b: c: d: e = (1.5-2.2):(1.5-2.3):(1.5-2.3):(2.5-3.3):(9-11)
(4) a: b: d: e = (0.5-1.2):(1.5-2.2):(0.5-1.3):(4-6)
(5) a: b: c: d: e = (0.5-1.2):(1.5-2.2):(0.5-1.2):(1.5-2.3):(6-8)
(6) a: b: c: d: e = (0.5-1.2):(1.5-2.2):(2.5-3.2):(3.5-4.3):(8-10)
According to one embodiment, the densified and oriented wire is obtained in the form of a multi-core structure, other than in the form of the conventional single-core tape shaped structure or round shaped structure. In this case, not only for the single-core wire but also for the twisted wire and the multi-core wire having a complex section, a superconductor is densified and orientiented by disposing a material expandable in volume under the heat-treatment at a portion of the wire. Moreover, even for a conductor with a twisted structure necessary for removing the alternating current loss in ac applications, such as a primary twisted cable, secondary twisted cable, or ternary twisted cable, the conductor is oriented and densified without any deterioration of the superconductivity.

Moreover, according to one embodiment, densifying utilizing the volume variation is applied to the conventional tape shaped and round sectional wires. For example, a long-sized wire previously fabricated is laminated on the above phase convertible insulating material, which are formed in a coil and heat-treated, thus fabricating a superconductor coil having a densified section in which crystals are oriented perpendicularly to the winding axis. The coil thus obtained is capable of generating a high magnetic field. The volume varying ratio of the volume variable material in the volume variation is in the range of from 1 to 80%, preferably, in the range of from 5 to 20%. More preferably, the volume variable material is adjusted such that the density of the superconductor core is equal to the true density after compactness. In winding a tape shaped conductor, using a transparent winding frame as a winding spool, the uniformity in the winding of the volume variable portion and the silver sheath is improved, and hence there is an extreme reduction in defects to be 1/50 times or less compared with the prior art.

According to another embodiment of the invention, the volume variable type conductor of the present invention is used for a magnet, current lead and cable, which are applicable for a superconductor generator, motor, SMES apparatus and NMR apparatus.

The volume variable type conductor of various embodiments of the present invention is superior in mechanical strength to the conventional one. Namely, the conventional filament having a structure that a powder of superconductor is coated with a silver sheath is disadvantageous in that the yield stress is significantly low to be about 1/10 times that of copper, and cannot be used for apparatuses where a strong electromagnetic force such as a magnetic stress is applied. Embodiments of the volume variable type conductor of the present invention enhance the yield stress comparable with that of copper by the mechanical strength of the sheath portion made of metal oxide, and in this regard, these embodiments of the present invention are effective in practical use.

The metal sheath materials of the present invention include a silver-based alloy containing silver, gold, palladium and 1 - 50 wt% of gold; and silver-based or gold-based alloy containing 1 to 50 wt% of palladium or magnesium. Moreover, a non-magnetic heat-insulating alloy is used as an outermost layer for reinforcement of the structure, as needed. In general, although a silver or gold alloy has a problem in drawing or rolling, the problem is solved according to some embodiments of the invention by using a silver-gold clad with a specified ratio as the sheath material; thinning it; and alloying it by diffusion reaction at the final heat-treatment.

The present invention will be more clearly understood with reference to the following examples:

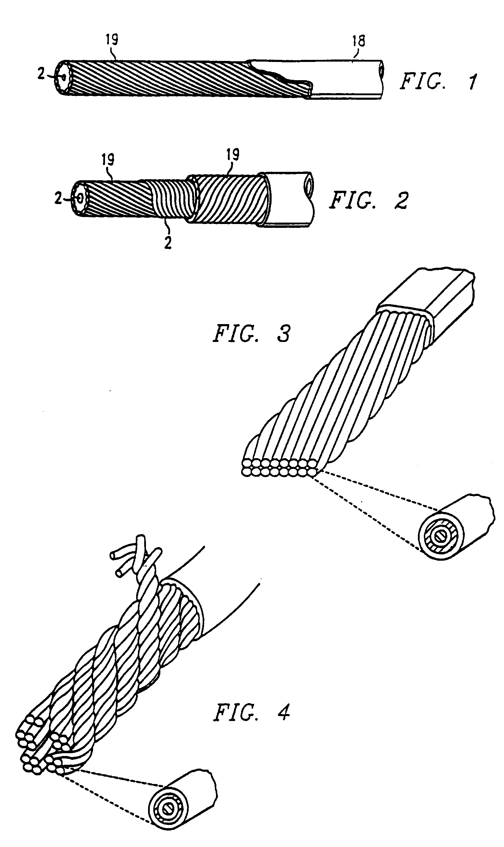

Fig. 1 is an example of a conductor with a twisted structure of the present invention. A tape-shaped wire 19 is wound in the manner shown in the figure.
Fig. 2 is an example of a conductor with a two-way twisted structure of the present invention. The tensile strength of the conductor thus fabricated is 20 kg/mm2, which is significantly improved compared with the value of 8 kg/mm2 of the conventional conductor to which a volume variable material is not added.

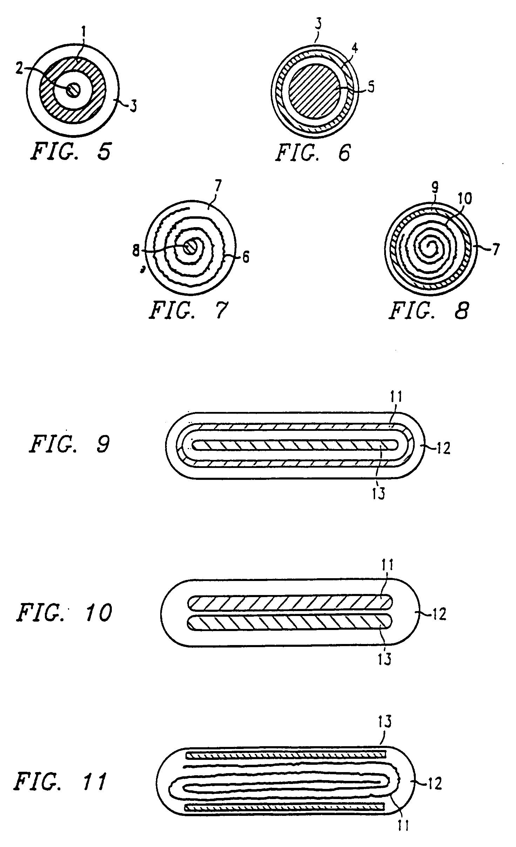

Fig. 3 is an example of a twist cable having a rectangular section using the wires of the present invention.
Fig. 4 is an example of a secondary twisted cable using the wires of the present invention. The wires can be each densified and are twisted without any deterioration of the performance. Moreover, the wires of the present invention can be twisted by the conventional method used for metal-based wires.
Fig. 5 is a transverse sectional view of an example of a wire of the present invention, which shows the state after the final heat-treatment. Titanium oxide 2 as the volume variable material is disposed inside an annularly disposed filament 1 made of T*e*₂(Ba_{0.8}, Sr_{0.4})₂Ca_{2.1}Cu₃O₁₀, and silver is disposed between the filament 1 and the titanium oxide 2 to prevent the contact therebetween. Silver as the sheath material 3 is disposed around the outermost periphery of the wire. Titanium, which is the material forming titanium oxide by heat-treatment, has a volume of about 1/2 that of the titanium oxide. Titanium is converted into titanium oxide by heat treatment in an oxidizing atmosphere. The filament 1 made of superconductor is pressurized at a high temperature by the volume expansion due to the phase conversion from metal titanium to titanium oxide, thus obtaining a densified structure.
The densification is not dependent on the wire diameter. Accordingly, there can be obtained a fine wire having a diameter in the range of 100 µm or less, preferably, in the range of 0.1 to 30 µm without any deterioration of the performance.
To adjust the expansion coefficient of the volume variable material such as metal titanium disposed at the center portion to be in a suitable range according to the shape of the conductor, there may be used a mixed powder of metal titanium and volume invariable oxide with a suitable mixing ratio. For example, the combination of alumina powder and metal titanium, or the combination of titanium oxide and metal titanium is effectively used. In this case, the expansion coefficient, which is dependent on the volume variation of metal titanium, can be adjusted to be in the range of from 1/100 to 1/2.
Fig. 6 is a sectional view of an example of a wire of the present invention, which shows the state after heat treatment. Oxide 5 of (T*e*_{0.5}, Pb_{0.5})₂Sr_{2.0}C_{2.2}Cu₃O₉ is disposed at the center portion, and a mixture 4 of nickel oxide and zirconia is disposed outside the oxide 5. In the mixed powder, zirconia and nickel are in the mixing ratio of 50:50 wt%, and only nickel is converted into nickel oxide. The volume varying ratio of the volume variable material can be adjusted at a specified value by the addition of a volume invariable material thereto. In general, to bury gaps in the superconductor, the volume expansion coefficient is in the range of about 10 to 200 vol%, preferably, in the range of 10 to 50 vol%.
Fig. 7 is a transverse sectional view of an example of a wire of the present invention. As the oxide superconductor, Bi_{2.1}Sr₂Ca_{1.2}Cu₂O₈ designated at numeral 6 is used. Magnesia 8 as the volume variable material is disposed at the center of the wire. Fig. 7 shows the state after heat-treatment. The volume variable material 8 before heat-treatment is in the form of metal magnesium. Metal magnesium is converted into magnesia by heat treatment. As a sheath material 6, a silver-8wt%gold alloy is used. The alloy is slightly difficult to be drawn. Alternatively, a clad of a gold pipe and a silver pipe with a specified weight ratio is heat-treated after drawing, to be thus alloyed.
Fig. 8 shows an example using an oxide superconductor made of Bi_{1.8}Pb_{0.4}Sr₂Ca_{2.2}Cu₃O₁₀ designated at numeral 10, and a volume variable material made of tin 9. In this example, a mixed powder of tin and tin oxide is used, in which the mixing ratio of tin is 10 wt% based on the total tin oxide. Tin is oxidized in the final heat-treatment, to be converted into tin oxide.
Figs. 9, 10 and 11 are sectional views of examples of wires of the present invention. These examples are different in sectional shape from each other. However, in each of the examples, Y₁Ba₂Cu₃O₁₀ designated at numeral 11 is used as an oxide superconductor; Ag-2wt%Pd alloy 12 is used as a sheath material; and niobium 13 is used as a volume variable material.

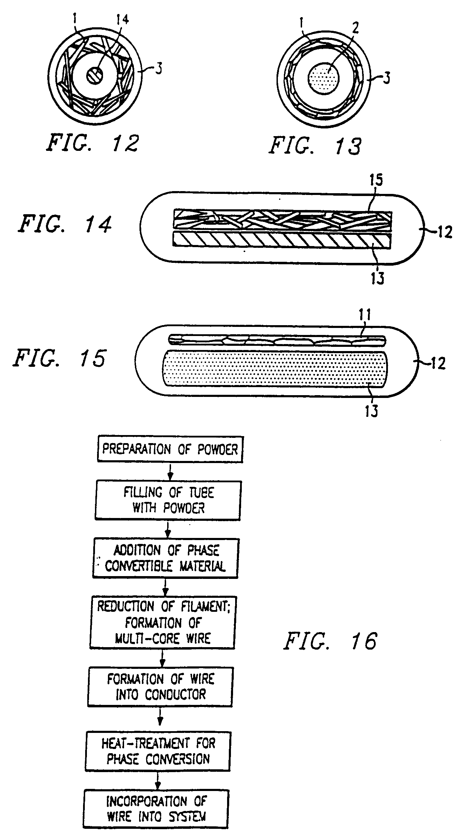

Fig. 12 is a sectional view having the same sectional construction as in Fig. 5, which shows a comparative example in which TiO₂ powder 14 previously oxidized is disposed at the center portion of the wire. Titania (TiO₂), which is not varied in volume in the final heat-treatment, is not expanded in volume. As shown in Fig. 12, gaps remain in oxide crystals 1, and therefore, the oxide crystals 1 are low in the orientation.
Fig. 13 shows an example in which the volume expansion occurs by the volume variation as in the case using metal titanium. Oxide crystals are radially compressed by heat-treatment, and are orientated in the C-faces thereof, that is, the transmission faces of electrons perpendicularly to the compression direction; and further, they are simultaneously densified.
Fig. 14 is a sectional view of an example of a tape-shaped wire before volume variation, which has the same sectional construction as in Fig. 10. Fig. 15 shows the tape-shaped wire after volume variation. As shown in Fig. 15, the gaps existing before the volume variation are densified by heat-treatment, and the C-faces of crystals are orientated along the tape surface.

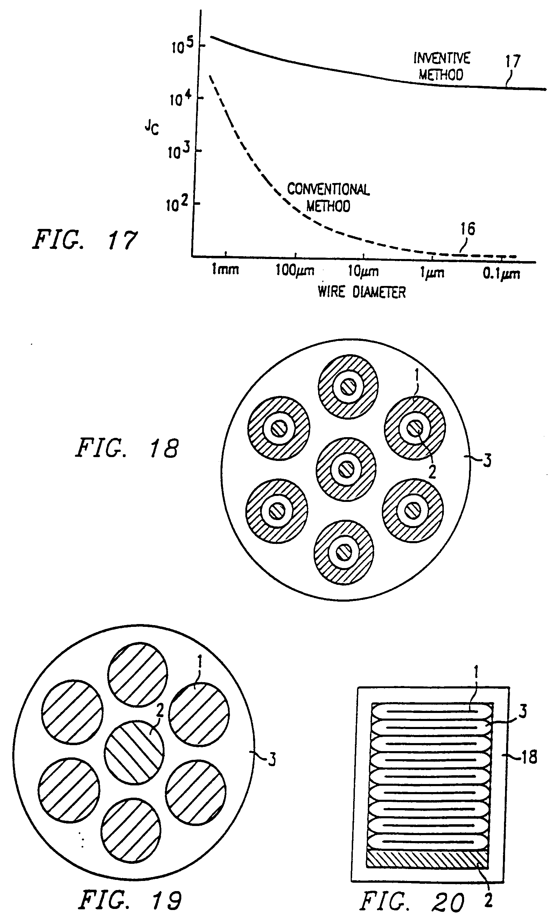

Fig. 16 is a flow-sheet showing a fabricating process for a wire of the present invention. In the procedure, a sheath tube is filled with a powder of superconductor. At this time, a volume variable material is simultaneously added. The tube is then thinned. After that, a multi-core wire may be formed, as needed. The wire is then formed into a conductor. The conductor is varied in volume by heat-treatment, and is incorporated in a superconductor system.
The final heat-treatment is preferably performed for 1 to 500 hr at a sintering temperature suitable for the superconductor ranging from 700 to 950 degrees C in an oxidizing atmosphere such as a 2 - 100% oxygen atmosphere.
The volume variable materials may include materials capable of being expanded in volume by heat-treatment and not reacting with the superconductor, for example, titanium, zirconium, thallium, indium, hafnium, nickel, manganese, magnesium, tin, lead, silicon, chromium, niobium-titanium compound, and the alloy thereof; aluminum or aluminum alloy; and titanium alloy, zirconium alloy, hafnium alloy, steel or stainless steel containing 1 - 10% aluminum.
The volume variable material may be used in the form of powder, tape or mesh.
The oxide superconductors may include known materials shown in Table 1.

**Table 1**

| | Composition | Remagnetizing. temp. (K) |
|---|---|---|
| La system | La_{1,8}Ba_{0.2}Cu₁O₄ | 30 |
| | La_{1.8}Sr_{0.2}Cu₁O₄ | 40 |
| | La_{1.8}Ca_{0.2}Cu₁O₄ | 30 |
| | La_{1.8}Na_{0.2}Cu₁O₄ | 40 |
| | La_{1.8}Cu₁O₄ | 40 |
| Y system | Y₁Ba₂Cu₃O₇ | 94 |
| | Y₁Ba₂Cu₃O₇ | 80 |
| | Ln₁Ba₂Cu₃O₇ | 90 |
| | Ca₁Ba₁La₁Cu₃O₇ | 80 |
| | Y₂Ba₄Cu₃O₇ | 80 |
| Bi system | Bi₂Sr₂Cu₁O₆ | 7 |
| | Bi₂Sr₂Ca₁Cu₂O₆ | 80 |
| | Bi₂Sr₂Ca₂Cu₃O₁₀ | 110 |
| T*l* system | T*l*₂Ba₂Cu₁O₆ | 90 |
| | T*l*₂Ba₂Ca₁Cu₂O₆ | 105 |
| | T*l*₂Ba₂Ca₂Cu₃O₁₀ | 122 |
| | T*l*₂Ba₂Ca₃Cu₄O₁₂ | 117 |
| | T*l*₁Ba₂Cu₁O₅ | 20 |
| | T*l*₁Ba₂Ca₁Cu₂O₇ | 91 |
| | T*l*₁Ba₂Ca₂Cu₃O₉ | 116 |
| | T*l*₁Ba₂Ca₃Cu₄O₁₁ | 122 |
| | T*l*₁Ba₂Ca₄Cu₅O₁₃ | 117 |
| | T*l*₁Ba₂Ca₁Cu₂O₇ | 75 |
| | T*l*₁Ba₂Ca₂Cu₃O₇ | 100 |
| | T*l*_{0.8}Pb_{0.2}Sr₂Ca₁Cu₂O₇ | 90 |
| | T*l*_{0.8}Pb_{0.2}Sr₂Ca₁Cu₈O₉ | 120 |

Fig. 17 shows a relationship between the wire diameter and the critical current density. In the thinning process designated at numeral 16 by the conventional powder rolling, powder is mechanically densified by only drawing using dies or rolling, as a result of which Jc of the wire is reduced by the thinning. On the other hand, in Inventive Example designated at numeral 17, in the thinning of the wire, the micro-gaps of the wire are applied with a chemical pressurizing force due to the expansion generated by the sufficient volume variation, so that the wire is not deteriorated in the performance by the thinning. The present invention is, therefore, more effective than the conventional wire, in the case of the multi-core wire, particularly, in the case of multi-core fine wire.
Figs. 18, 19, 20 and 21 are transverse sectional views of examples of multi-core wires of the present invention. Fig. 18 shows a wire in which 7 pieces of filaments shown in Fig. 5 are collected. Fig. 19 shows the multi-core wire in which a volume variable material is disposed at the center. Fig. 20 shows the multi-core wire in which tape-shaped conductors are collected, wherein a volume variable material 2 is disposed such that a pressurizing force generated by volume variation is applied perpendicularly to the tape surface, and the wire is coated with stainless steel 18 as a whole.

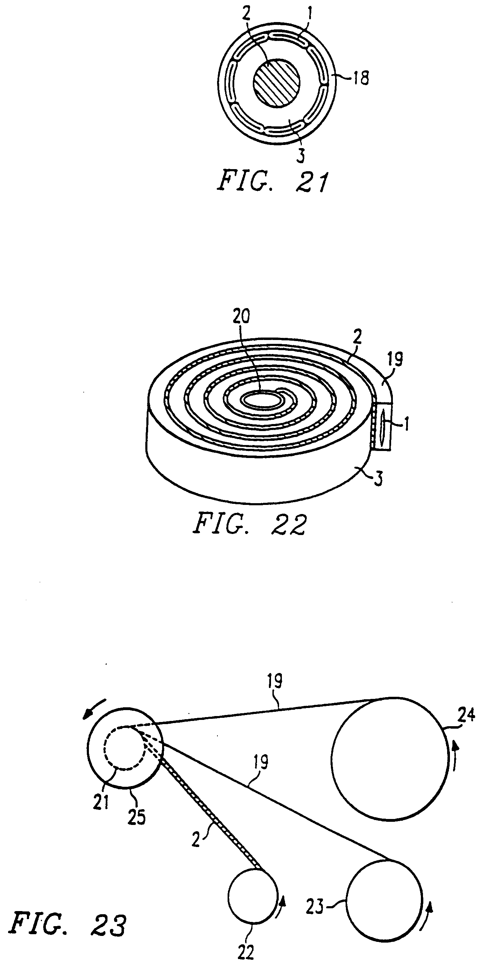

Fig. 21 shows an example of a multi-core wire in which tape-shaped conductors are collected in a round shape.
Using the wires of the present invention, there can be realized a twisted cable structure in which the alternating current loss is lowered.
Fig. 22 shows an example in which the volume varying method of the present invention is applied to the densifying for a pan-cake coil fabricated using a tape shaped wire. As shown in this figure, a volume variable material 2 is overlappingly wound on a tape shaped wire 19. Silver 20 is used as a winding core. The pan-cake coil thus obtained is heat-treated, to realize a superconductor coil which is densified and oriented in the C-faces of crystals along the winding peripheral direction. The thickness of the tape shaped wire material is preferably in the range of from 0.05 to 0.2 mm. The tape shaped wires in the number of 2 to 6 pieces may be laminated. The volume variable material is made of a tape shaped metal, and preferably, it has a thickness ranging from 10 to 100 µm. Such a pan-cake coil is fabricated using a winding machine shown in Fig. 23. The tape shaped volume variable material 2 is fed from a feed portion 22 with a specified tension. The wires 19 are fed from the feed portions 23 and 24 with a specified tension. The coil is wound around a winding portion 21. By use of a winding frame 25 made of transparent plastic or the like, it is possible to extremely easily find defects of the coil upon winding, to increase the quality of the coil, and hence to extremely enhance the manufacturing yield by 20 times that of the conventional method.

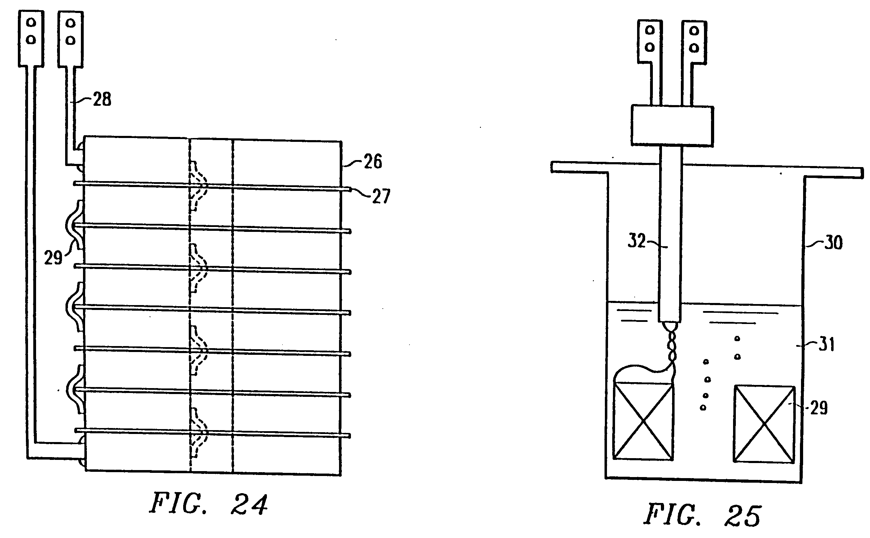

Fig. 24 shows an example of a coil system of the present invention in which 8 pieces of the pan-cake coils 26 thus fabricated are laminated. The pan-cake coils are separated from each other by means of alumina plates 27, and are connected to each other by means of silver tapes 29. The silver tape may be replaced by a superconductor wire. The coil generates 3 tesla at 63 K.
Fig. 25 shows an example of a solenoid coil system fabricated using the twisted cable shown in Fig. 4. A solenoid coil 29 is disposed within a cryostat 30, and is dipped in liquid helium 31. A current lead 32 is made of a two-way twisted conductor shown in Fig. 2. The coil system generates 5 tesla at 4.2 K.

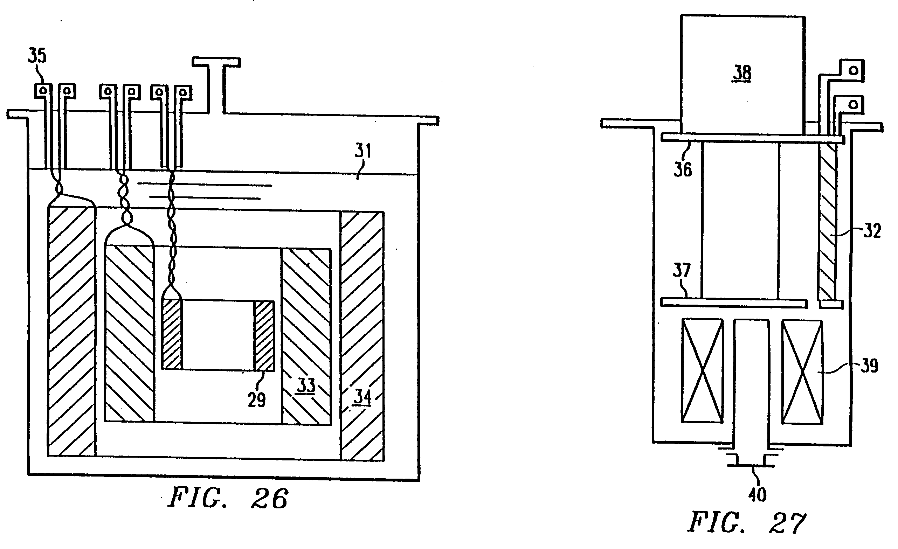

Fig. 26 is a system composed of a niobium-titanium compound coil 34, niobium-tin compound coil 33 and an oxide superconductor 29. A current lead is made of a twisted conductor shown in Fig. 3, and is disposed as shown in Fig. 26. The coil generates 25 tesla at 4.2 K.
Fig. 27 is an example of a coil system combined with a helium refrigerator. The pan-cake coil shown in Fig. 25 is used as a superconductor coil 39.

In Fig. 27, a two-way twisted conductor shown in Fig. 2 is used as a current lead. In the refrigerator, the current lead is kept to be 70 K at the portion of a first stage, and to be 20 K at a second stage. The cryostat is evacuated and heat-insulated, and a magnet is kept at 20 K. By opening a flange 40, there can be obtained a magnetic field of 3 tesla in a room temperature space. Moreover, the system shown in this figure may be used in the state to be vertically reversed or to be tilted, that is, it is not limited in terms of the geometrical disposition.

The coil systems described above are only illustrative, and may be applied to ac superconducting fields, such as an NMR, MRI, SMES, superconductor generator, superconductor motor, accelerator and the like.

## Claims

1. An oxide superconductor comprising:
a volume variable portion (2) increased in volume by heat-treatment;
a superconducting portion made of an oxide superconductor material which is formed around an outer periphery of said volume variable portion (2); and
a sheath portion (3) formed around an outer periphery of said superconducting portion.

2. An oxide superconductor comprising:
a superconducting portion made of an oxide superconductor material;
a volume variable portion (2) increased in volume by heat-treatment, which is formed around the outer periphery of said superconducting portion; and
a sheath portion (3) formed around said volume variable portion (2).

3. An oxide superconductor according one of the preceeding claims wherein said sheath portion (3) is chemically inactive with said oxide superconducting portion during heat-treatment.

4. An oxide superconductor according to one of the preceeding claims wherein said volume variable portion (2) comprises a high melting point metal;

5. An oxide superconductor according to one of the preceeding claims wherein said high melting point metal comprises aluminum.

6. An oxide superconductor according to one of the preceeding claims wherein said high melting point metal comprises titanium.

7. An oxide superconductor according to one of the preceeding claims wherein said high melting point metal comprises zirconium.

8. An oxide superconductor according one of the preceeding claims wherein said high melting point metal comprises steel and aluminum, said aluminum being in an amount of from 1 to 10%.

9. An oxide superconductor according to one of the preceeding claims wherein said high melting point metal comprises stainless steel and aluminum, said aluminum being in an amount of from 1 to 10%.

10. An oxide superconductor according to one of the preceeding claims wherein said sheath portion (3) comprises tin.

11. An oxide superconductor according to one of the preceeding claims wherein said sheath portion (3) comprises lead.

12. An oxide superconductor according to one of the preceeding claims wherein said sheath portion (3) comprises thallium.

13. An oxide superconductor according to one of the preceeding claims wherein said sheath portion (3) comprises indium.

14. An oxide superconductor according to one of the preceeding claims wherein said superconducting portion, said volume variable portion (2) and said sheath portion (3) have flat sections which are laminated in parallel with each other.

15. An oxide superconductor according to one of the preceeding claims wherein said sheath portion (3) is formed into a mesh.

16. An oxide superconductor according to one of the preceeding claims wherein said sheath portion (3) is formed into a wire.

17. An oxide superconductor according to one of the preceeding claims wherein said sheath portion (3) is formed into a tape (19).

18. A method of fabricating an oxide superconductor comprising the steps of:
filling a sheath portion (3) with a precursor of an oxide superconductor to form a filament (1);
forming said filament (1) into a twisted conductor; and
heat-treating said conductor.

19. A method of fabricating an oxide superconductor according to claim 18, further comprising thinning said sheath portion (3) and forming the filaments (1) into a twisted conductor.

20. A method of fabricating an oxide superconductor comprising the steps of:
filling a sheath portion (3) with a precursor of an oxide superconductor and a volume variable material to form a filament (1);
forming said filament (1) into a twisted conductor; and
heat-treating said conductor to vary the volume of said volume variable material.

21. A method of fabricating an oxide superconductor according to claim 20, further comprising thinning said sheath portion (3) and forming the filaments (1) into a twisted conductor.

22. A method of fabricating an oxide superconductor according to claim 18 or 20, wherein said filaments (1) are formed into a multi-core wire.

23. A method of fabricating an oxide superconductor according to claim 22, wherein said multi-core wire is formed into a twisted conductor.

24. A method of fabricating an oxide superconductor according to claim 22, further comprising forming said conductor into a solenoid coil and heat-treating said conductor to vary the volume.

25. A method of fabricating an oxide superconductor according to claim 22, further comprising forming said conductor into a pan-cake coil and heat-treating said conductor to vary the volume.

26. A method of fabricating an oxide superconductor according to claim 22, further comprising forming said conductor into a cable and heat-treating said conductor to vary the volume.
